# EUROPEAN PATENT APPLICATION

(11) **EP 4 554 194 A1**
(43) Date of publication of application: **14.05.2025**
(21) Application number: 23850479.9
(22) Date of filing: 04.08.2023
(51) Int. Cl.: H04M 1/02, H05K 1/14, H05K 1/02, H05K 3/28, H05K 3/46

(54) **MULTI-LAYERED FLEXIBLE PRINTED CIRCUIT BOARD AND ELECTRONIC DEVICE COMPRISING SAME**

(30) Priority: 05.08.2022 KR 20220098091; 09.08.2022 KR 20220099360
(71) Applicant: Samsung Electronics Co., Ltd., Suwon-si, Gyeonggi-do 16677 (KR)
(72) Inventor: JUNG, Youngjin, Suwon-si, Gyeonggi-do 16677 (KR); KWON, Kihwan, Suwon-si, Gyeonggi-do 16677 (KR); PARK, Honjeong, Suwon-si, Gyeonggi-do 16677 (KR); CHO, Sujin, Suwon-si, Gyeonggi-do 16677 (KR); CHUN, Woosung, Suwon-si, Gyeonggi-do 16677 (KR)
(74) Representative: HGF
(86) International application number: PCT/KR2023/011462
(87) International publication number: WO 2024/029979

(57) **Abstract**

A multi-layered flexible printed circuit board of the present disclosure may comprise: a first flexible printed circuit board (FPCB) including a first curved area in which a conductive layer for signal transfer is arranged, wherein the first FPCB includes a first dummy area extending from the first curved area; a second FPCB including a second curved area in which a conductive layer for signal transfer is arranged, wherein the second FPCB includes a second dummy area extending from the second curved area; and a bonding layer in which the first dummy area and the second dummy area are bonded to each other.

## Description

### [Technical Field]

The disclosure relates to a multilayer flexible printed circuit board and an electronic device including the same.

### [Background Art]

Electronic devices are gradually becoming slimmer and more rigid, being enhanced in design aspects, and being improved to differentiate functional elements thereof. Electronic devices are gradually evolving from a uniform rectangular shape to diverse shapes. An electronic device may have a transformable structure that is convenient to carry and enables the use of a large-screen display. Large-screen displays are evolving from flexible types to fully foldable displays.

In a foldable electronic device with a foldable display, since it is possible to use the large area of the display in an unfolded state and the entire volume of the electronic device is reduced in the folded state, it is possible to improve both the usability and portability.

### [Disclosure of Invention]

### [Technical Problem]

The electronic device of the disclosure may include foldable housings, and each housing may include boards.

In the electronic device of the disclosure, the boards included in the respective housings may be electrically connected using a multilayer flexible printed circuit board (FPCB).

The disclosure bonds at least a portion of the multilayer flexible printed circuit board.

### [Solution to Problem]

A multilayer flexible printed circuit board of the disclosure may include a first flexible printed circuit board (FPCB) including a first curved area in which a conductive layer for signal transmission is disposed, and a second FPCB including a second curved area in which a conductive layer for signal transmission is disposed. The first FPCB may include a first dummy area extending from the first curved area, the second FPCB may include a second dummy area extending from the second curved area. The multilayer FPCB may include to which the first dummy area and the second dummy area are bonded.

An electronic device according to the disclosure may include a hinge, a first housing connected to the hinge, and a second housing connected to the hinge and configured to be folded with the first housing about the hinge.

The electronic device of the present disclosure may include a first printed circuit board included in the first housing, a second printed circuit board included in the second housing, a battery included in the second housing and disposed in a direction perpendicular to the second PCB, and a multilayer flexible printed circuit board (FPCB) placed on the battery to connect the first PCB and the second PCB.

The multilayer flexible printed circuit board of the disclosure may include a first FPCB including a first curved area in which a conductive layer for signal transmission is disposed, a second FPCB including a second curved area in which a conductive layer for signal transmission is disposed. The first FPCB may include a first dummy area extending from the first curved area, and the second FPCB may include a second dummy area extending from the second curved area. The first FPCB may include a bonding layer to which first dummy area and the second dummy area are bonded.

### [Advantageous Effects of Invention]

In the multilayer flexible printed circuit board of the disclosure, since at least some areas are bonded, interlayer separation may be prevented.

Since the interlayer separation is prevented, the multilayer flexible printed circuit board of the disclosure may be protected from external impact.

The multilayer flexible printed circuit board of the disclosure may make it possible to secure the capacity of a battery disposed therewith by bonding at least some areas using dummy areas with thin layers.

### [Brief Description of Drawings]

FIG. 1 is a block diagram of an electronic device according to an embodiment of the disclosure in a network environment.
FIGS. 2A and 2B are front and rear views of an electronic device according to an embodiment of the disclosure in an flat state.
FIGS. 3A and 3B are front and rear views of the electronic device according to an embodiment of the disclosure in a folded state.
FIG. 4A is an exploded perspective view of the electronic device according to an embodiment of the disclosure.
FIG. 4B is a view illustrating an arrangement structure of hinge devices in an electronic device according to an embodiment of the disclosure.
FIG. 5 is a view illustrating an example of implementing a multilayer flexible printed circuit board in an electronic device according to an embodiment of the disclosure.
FIG. 6 is a view illustrating an example of implementing the arrangement of a multilayer flexible printed circuit board and other components in the electronic device according to an embodiment of the disclosure.
FIG. 7 is a front view of a multilayer flexible printed circuit board according to an embodiment of the disclosure.
FIG. 8 is a view schematically illustrating curved areas and dummy areas according to an embodiment of the disclosure.
FIG. 9 is a view specifically illustrating curved areas and dummy areas according to an embodiment of the disclosure.
FIG. 10 is a view schematically illustrating a cross-section of the multilayer flexible printed circuit board of FIG. 7 according to an embodiment of the disclosure, cut along line A-B.
FIG. 11 is a view specifically illustrating a cross-section of the multilayer flexible printed circuit board of FIG. 7 according to an embodiment of the disclosure, cut along line A-B.

### [Mode for the Invention]

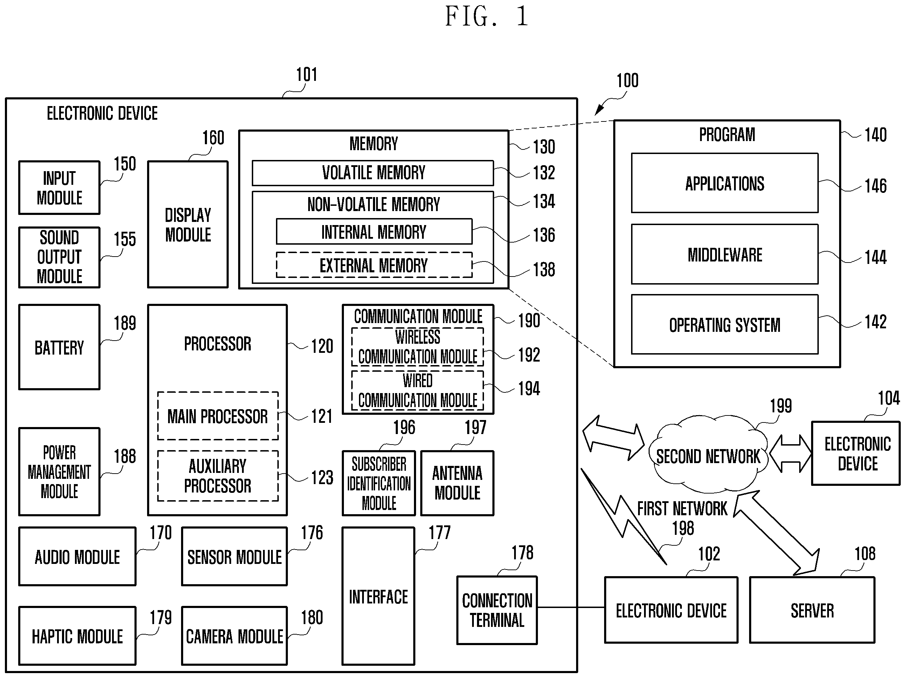

Fig. 1 is a block diagram illustrating an electronic device 101 in a network environment 100 according to an embodiment.

Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. **In** some embodiments, at least one of the components (e.g., the connecting terminal 178) may be omitted from the electronic device 101, or one or more other components may be added in the electronic device 101. **In** some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

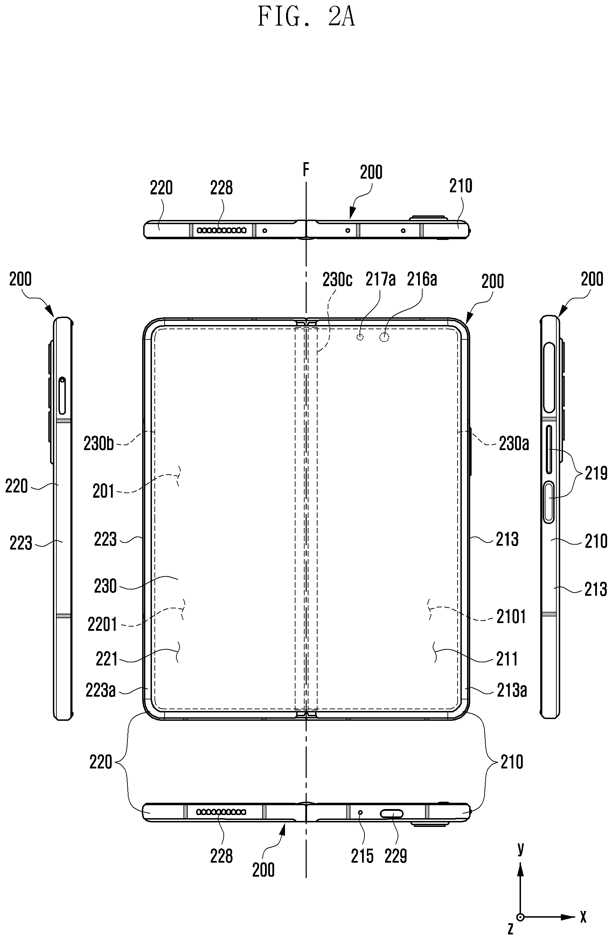

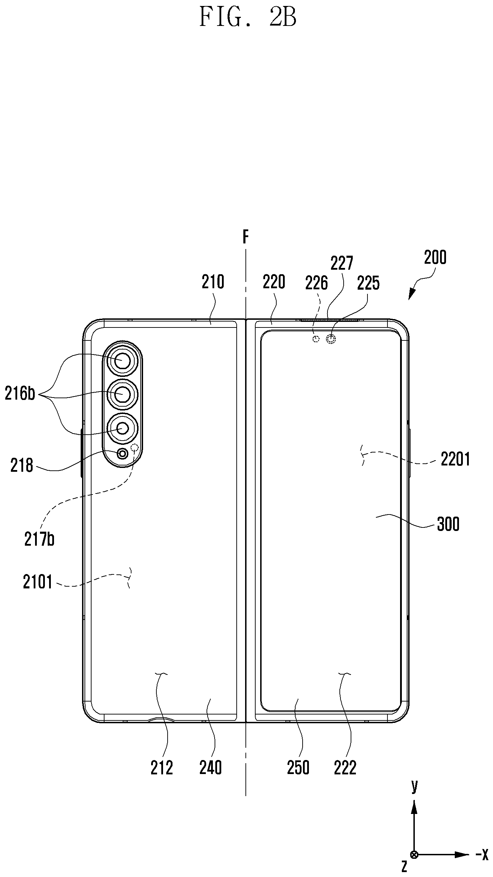

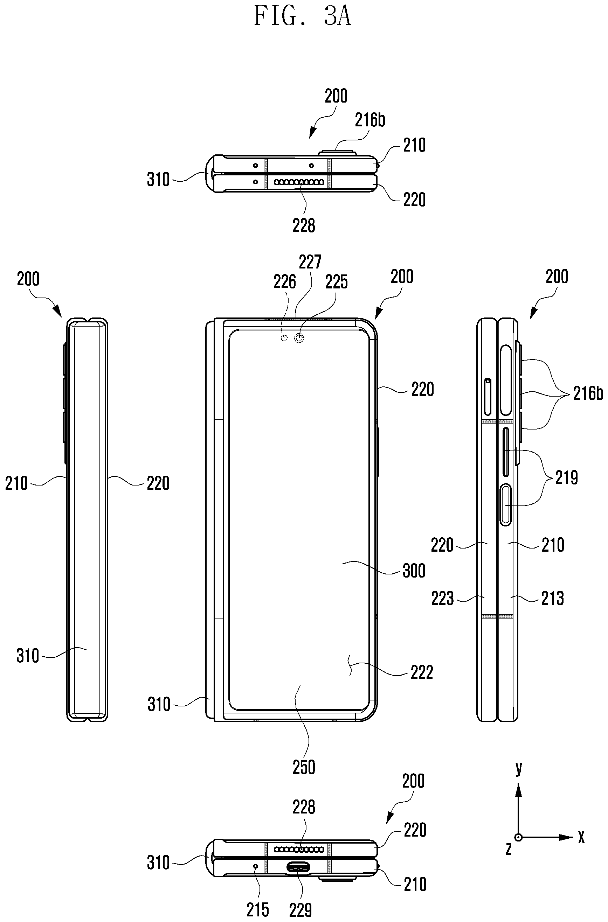

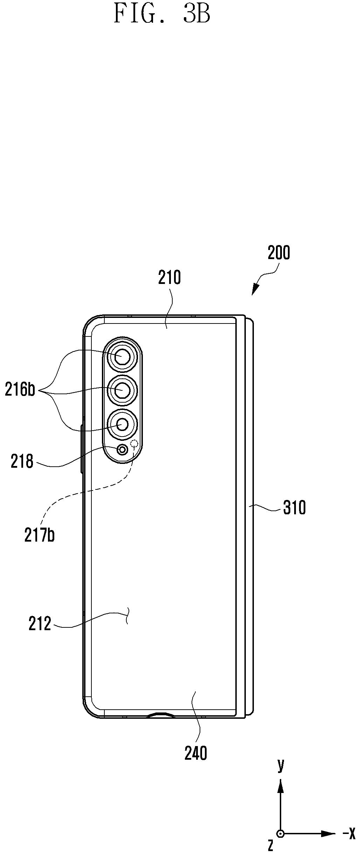

FIGS. 2A and 2B are front and rear views of an electronic device according to an embodiment of the disclosure in an flat state. FIGS. 3A and 3B are front and rear views of the electronic device according to an embodiment of the disclosure in a folded state.

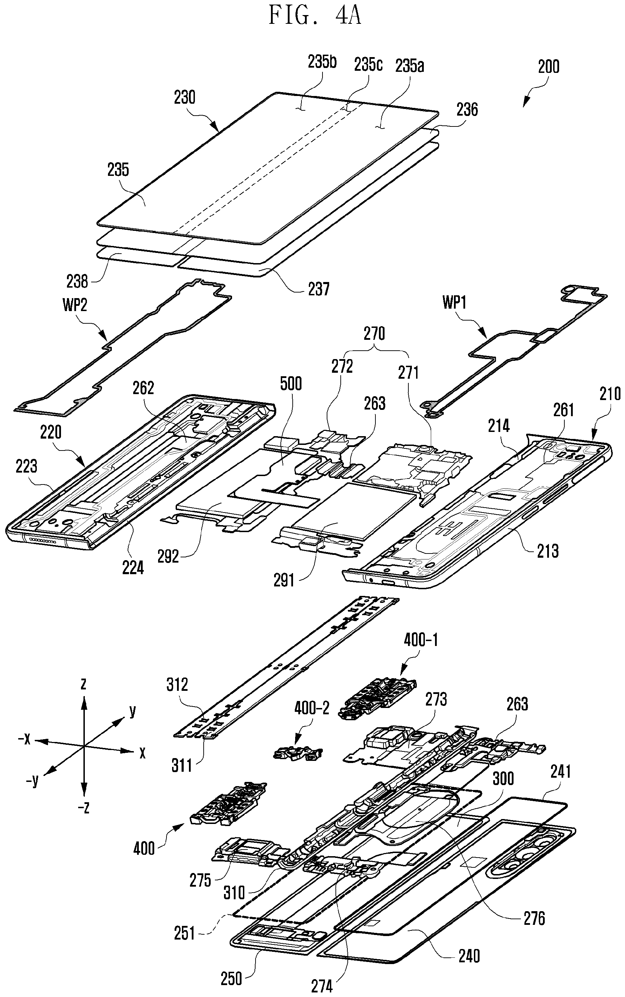

Referring to FIGS. 2A to 3B, the electronic device 200 may include first and second housings 210 and 220 (e.g., a foldable housing structure) that are coupled to be rotatable about a folding axis F via at least one hinge device (e.g., the hinge device 400 and 400-1 in FIG. 4A) (e.g., a hinge module or a hinge), a first display 230 (e.g., a flexible display, a foldable display, or a main display) disposed on the first and second housings 210 and 220, and/or a second display 300 (e.g., a sub-display) disposed on the second housing 220.

According to an embodiment, the first housing 210 and the second housing 220 may be disposed on opposite sides of the folding axis F, may have shapes that are generally symmetrical to each other with respect to the folding axis F, and may be folded to match each other. According to an embodiment, the first housing 210 and the second housing 220 may be folded asymmetrically with respect to the folding axis F. According to an embodiment, the angle or distance between the first housing 210 and the second housing 220 may vary depending on the state of the electronic device 200. For example, the angle or distance between the first housing 210 and the second housing 220 may vary depending on whether the electronic device is in the flat state, the folded state, or the intermediate state. The folded state may be a state in which the first housing (210) and the second housing (220) are completely folded so that the first display (230) is not exposed to the outside. The intermediate state may be a state in which the first housing (210) and the second housing (220) are flexed at a certain angle. The flat state may be a state in which the first housing (210) and the second housing (220) are completely unfolded.

According to an embodiment, the first housing 210 may be connected to the at least one hinge device (e.g., the hinge devices 400 and 400-1 in FIG. 4A) and may include a first surface 211 disposed to face the front of the electronic device 200 when the electronic device 200 is in the flat state, a second surface 212 facing away from the first surface 211, and a first side surface frame 213 surrounding at least a portion of a first space 2101 between the first surface 211 and the second surface 212. According to an embodiment, the second housing 220 may be connected to the at least one hinge device (e.g., the hinge devices 400 and 400-1 in FIG. 4A) and may include a third surface 221 disposed to face the front of the electronic device 200 when the electronic device 200 is in the flat state, a fourth surface 222 facing away from the third surface 221, and a second side surface frame 223 surrounding at least a portion of a second space 2201 between the third surface 221 and the fourth surface 222. According to an embodiment, the first surface 211 may be oriented in substantially the same direction as the third surface 221 when the electronic device 200 is in the flat state and may at least partially face the third surface 221 when the electronic device 200 is in the folded state. According to an embodiment, the electronic device 200 may include a recess 201 provided to accommodate the first display 230 through structural coupling between the first housing 210 and the second housing 220. According to an embodiment, the first housing 210 may include a first protection frame 213a (e.g., a first decoration member or a first protection cover) which is disposed to overlap the edges of the first display 230 when the first display 230 is viewed from above, thereby covering the edges of the first display 230 to be invisible from the outside. According to an embodiment, the first protection frame 213a may be coupled with the first side surface frame 213. According to an embodiment, the first protection frame 213a may be integrated with the first side surface frame 213. According to an embodiment, the second housing 220 may include a second protection frame 223a (e.g., a second decoration member or a second protection cover) which is disposed to overlap the edges of the first display 230 when the first display 230 is viewed from above, thereby covering the edges of the first display 230 to be invisible from the outside. According to an embodiment, the second protection frame 223a may be coupled with the second side surface frame 223. According to an embodiment, the second protection frame 223a may be integrated with the second side surface frame 223. According to an embodiment, the first and second housings 210 and 220 may not include the first protection frame 213a and the second protection frame 223a, respectively.

According to various embodiments, the hinge housing 310 (e.g., a hinge cover) may be disposed between the first housing 210 and the second housing 220 to conceal at least a portion of at least one hinge device (e.g., the hinge device 400 and 400-1 in FIG. 4A). According to an embodiment, the hinge housing 310 may be concealed by a portion of the first housing 210 and the second housing 220 or exposed outside, depending on the state of the electronic device 200 (e.g., the flat state, the folded state, or the intermediate state). For example, when the electronic device 200 is in the flat state, at least a portion of the hinge housing 310 may be substantially invisible from the outside by being disposed to be concealed by the first housing 210 and the second housing 220. According to an embodiment, when the electronic device 200 is in the folded state, at least a portion of the hinge housing 310 may be disposed between the first housing 210 and the second housing 220 to be visible from the outside. According to an embodiment, when the electronic device is in the intermediate state in which the first housing 210 and the second housing 220 are folded with a certain angle, the hinge housing 310 may be at least partially visible from the outside between the first housing 210 and the second housing 220. According to an embodiment, the hinge housing 310 may include a curved surface.

According to an embodiment, the electronic device 200 may include at least one of the following components: input devices 215, sound output devices 227 and 228, sensor modules 217a, 217b, and 226, camera modules 216a, 216b, and 225, key input devices 219, indicators (not illustrated), or connector ports 229, in which the components are disposed on or in the first housing 210 and/or the second housing 220. **In** an embodiment, at least one of the components may be omitted from the electronic device 200, or one or more other components may be additionally included in the electronic device 200.

According to an embodiment, the one or more displays 230 and 300 may include a first display 230 (e.g., a flexible display) disposed to be supported from the first surface 211 of the first housing 210 to the third surface 221 of the second housing 220 across at least one hinge device (e.g., the hinge devices 400 and 400-1 in FIG. 4A), and a second display 300 disposed in the inner space of the second housing 220 to be at least partially visible from the outside through the fourth surface 222. **In an** embodiment, the second display 300 may be disposed in the inner space of the first housing 210 to be visible from the outside through the second surface 212. According to an embodiment, when the electronic device 200 is in the intermediate state, the electronic device 200 may be controlled such that the first display 230 and/or the second display 300 can be used based on the angle (folding angle) between the first housing 210 and the second housing 220.

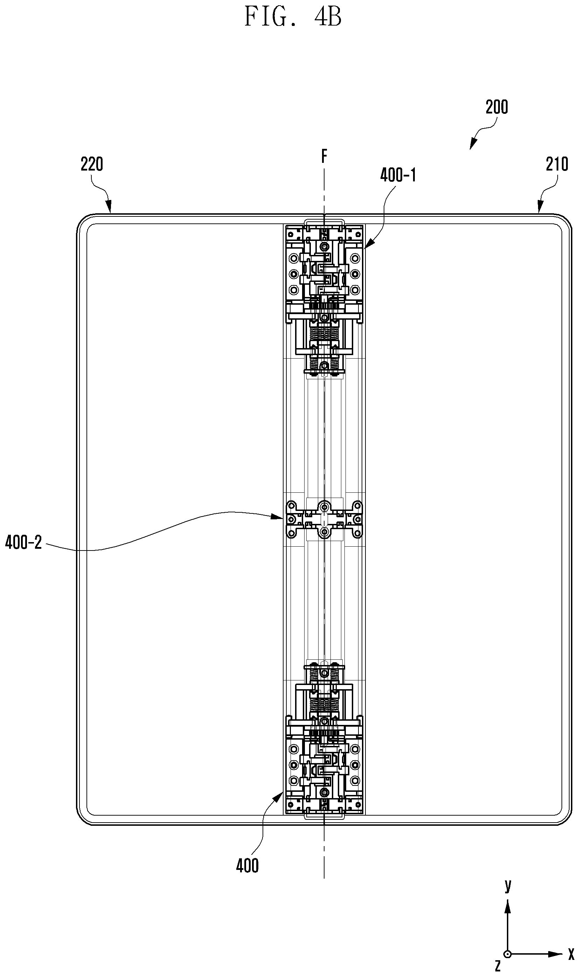

According to an embodiment, the first display 230 may include a flexible display, at least a portion of which is transformable into a flat shape or a curved shape. According to an embodiment, the first display 230 may include a first area 230a corresponding to the first housing 210 and a second area 230b corresponding to the second housing 220. According to an embodiment, the first display 230 may include a folding area 230c including a portion of the first area 230a and a portion of the second area 230b with reference to the folding axis F. According to an embodiment, at least a portion of the folding area 230c may include an area corresponding to the at least one hinge device (e.g., the hinge devices 400 and 400-1 in FIG. 4). According to an embodiment, the division of the area of the first display 230 may be an exemplary division for explanation based on the pair of housings 210 and 220 and at least one hinge device (e.g., the hinge devices 400 and 400-1 in FIG. 4A). According to an embodiment, the first display 230 may be illustrated as a single seamless full screen substantially through the pair of housings 210 and 220 and the at least one hinge device (e.g., hinge devices 400 and 400-1 in FIG. 4A). According to an embodiment, the first area 230a and the second area 230b may have an overall symmetrical shape or a partially asymmetrical shape with respect to the folding area 230c.

According to an embodiment, when the electronic device 200 is in the flat state (e.g., the state in FIGS. 2A and 2B), the first housing 210 and the second housing 220 form an angle of about 180 degrees therebetween, and the first area 230a, the second area 230b, and the folding area 230c of the first display 230 may be oriented in substantially the same direction (e.g., the z-axis direction) while substantially forming the same plane. According to an embodiment, when the electronic device 200 is in the folded state (e.g., FIGS. 3A and 3B), the first display 230 may be folded such that the first area 230a and the second area 230b face each other (in-folding type). According to an embodiment, when the electronic device 200 is in the folded state, the first housing 210 may rotate by an angle of about 360 degrees with respect to the second housing 220 to be folded such that the second surface 212 and the fourth surface 222 face each other. **In** this case, the first display 230 may be disposed to be visible from the outside (out-folding type).

According to an embodiment, when the electronic device 200 is in the folded state (e.g., the state in FIGS. 3A and 3B), the first surface 211 of the first housing 210 and the third surface 221 of the second housing 220 may be disposed to face each other. According to an embodiment, when the electronic device 200 is in the folded state (e.g., the state in FIGS. 3A and 3B), the angle formed by the first housing 210 and the second housing 220 may range from about 0 degrees to about 10 degrees. **In** this case, the folding area 230c of the first display 230 may be bent into a curved shape (e.g., a "U" shape or a water drop shape) in the inner space of the electronic device 200.

**In** an embodiment, when the electronic device 200 is in the intermediate state, the first housing 210 and the second housing 220 may maintain at least one predetermined folding angle (free stop function) through the at least one hinge device (e.g., the hinge devices 400 and 400-1 in FIG. 4A). **In** an embodiment, the first housing 210 and the second housing 220 may be continuously moved in an unfolding direction or a folding direction based on a predetermined folding angle (e.g., 45 degrees) via the at least one hinge device (e.g., the hinge devices 400 and 400-1 in FIG. 4A).

According to an embodiment, the electronic device 200 may include a first rear surface cover 240 disposed on the second surface 212 of the first housing 210 and a second rear surface cover 250 disposed on the fourth surface 222 of the second housing 220. In an embodiment, at least a portion of the first rear surface cover 240 may be integrated with the first side surface frame 213. In an embodiment, at least a portion of the second rear surface cover 250 may be integrated with the second side surface frame 223. According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials. According to an embodiment, the second rear surface cover 250 may be made of a substantially transparent plate of, for example, glass or polymer. **In** this case, the second display 300 may be disposed in the inner space of the second housing 220 to be visible from the outside through the second rear surface cover 250.

According to an embodiment, the input device 215 may include at least one microphone. According to various embodiments, the sound output devices 227 and 228 may include at least one speaker. According to an embodiment, the sound output devices 227 and 228 may include a call receiver 227 disposed through the fourth surface 222 of the second housing 220, and an external speaker 228 disposed through at least a portion of the second side surface frame 223 of the second housing 220. In an embodiment, the input devices 215, the sound output devices 227 and 228, and the connector ports 229 may be disposed in the spaces of the first housing 210 and/or the second housing 220, and may be exposed outside through one or more holes provided in the first housing 210 and/or the second housing 220. In an embodiment, the one or more holes provided in the first housing 210 and/or the second housing 220 may be commonly used for the input device 215 and the sound output devices 227 and 228. In an embodiment, the sound output devices 227 and 228 may include a speaker that is not exposed through the one or more holes provided in the first housing 210 and/or the second housing 220 (e.g., a piezo speaker).

According to an embodiment, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. In an embodiment, the electronic device 200 may include a flash 218 located near the second camera module 216b. According to an embodiment, the camera modules 216a, 216b, and 225 may include one or more lenses, an image sensor, and/or an image signal processor. In an embodiment, at least one of the camera modules 216a, 216b, and 225 may include two or more lenses (e.g., wide-angle and telephoto lenses) and two or more image sensors, and may be disposed together on one surface of the first housing 210 and/or the second housing 220.

According to an embodiment, the sensor modules 217a, 217b, and 226 may generate electrical signals or data values corresponding to an internal operating state or an external environmental state of the electronic device 200. According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In an embodiment, the sensors 217a, 217b, and 226 may include at least one of a gesture sensor, a grip sensor, a color sensor, an infrared (IR) sensor, an illumination sensor, an ultrasonic sensor, an iris recognition sensor, or a distance detection sensor (e.g., a time-of-flight (TOF) sensor or a light detection and ranging (LiDAR) sensor).

According to an embodiment, the electronic device 200 may further include at least one of sensor modules (not illustrated) such as an air pressure sensor, a magnetic sensor, a biometric sensor, a temperature sensor, a humidity sensor, or a fingerprint recognition sensor. **In** an embodiment, the fingerprint recognition sensor may be disposed through at least one of the first side surface frame 213 of the first housing 210 and/or the second side surface frame 223 of the second housing 220.

According to an embodiment, the key input devices 219 may be disposed to be exposed to the outside through the first side surface frame 213 of the first housing 210. **In** an embodiment, the key input devices 219 may be disposed to be exposed outside through the second side surface frame 223 of the second housing 220. **In an** embodiment, the electronic device 200 may not include some or all of the above-mentioned key input devices 219, and a key input device 219, which is not included, may be implemented in another form, such as a soft key, on at least one display 230 or 300. As an embodiment, the key input devices 219 may be implemented by using a pressure sensor included in the at least one display 230 or 300.

According to an embodiment, the connector ports 229 may include a connector (e.g., a USB connector or an interface connector port module (IF module)) configured to transmit/receive power and/or data to and from an external electronic device. **In** an embodiment, the connector ports 229 may further include a separate connector port (e.g., an ear jack hole) for performing a function for transmitting/receiving an audio signal to and from the external electronic device or an audio signal transmitting/receiving function.

According to an embodiment, one or more camera modules 216a and 225, and/or one or more sensor modules 217a and 226 may be disposed in the inner space of at least one of the first and second housings 210 and 220, below active areas (display areas) of one or more displays 230 and 300. According to an embodiment, the one or more camera modules 216a and 225, and/or the one or more sensor modules 217a and 226 may be optically exposed outside through openings or transmissive areas formed in the one or more displays 230 and 300.

According to an embodiment, areas in which the one or more displays 230 and 300 and the one or more camera modules 216a and 225 face each other may be provided as transmissive areas with a predetermined transmittance as portions of content display areas.

According to an embodiment, the transmissive area may have a transmittance ranging from about 5% to about 20%.

According to an embodiment, the transmissive areas may each include an area overlapping the effective area (e.g., a view angle area) of the one or more camera modules 216a and 225 through which light imaged by an image sensor to generate an image passes. For example, the transmissive areas of the one or more displays 230 and 300 may each include an area having a lower pixel density than the periphery. For example, the one or more camera modules 216a and 225 may include an under-display camera (UDC) or an under-panel camera (UPC).

In an embodiment, the one or more camera modules 216a and 225 and/or the one or more one sensor modules 217a and 226 may be disposed so as not to be visually exposed through the display.

FIG. 4A is an exploded perspective view of an electronic device 200 according to an embodiment of the disclosure. FIG. 4B is a view illustrating an arrangement structure of hinge devices in an electronic device according to an embodiment of the disclosure.

According to an embodiment, the electronic device 200 may include a first display 230 (e.g., a flexible display), a second display 300, one or more hinge devices 400-1 and 400-2, a pair of support frames 261 and 262, one or more boards 270 (e.g., a printed circuit board PCB), a first housing 210, a second housing 220, a first rear surface cover 240, and/or a second rear surface cover 250.

According to an embodiment, the first display 230 may include a display panel 235 (e.g., a flexible display panel) and a support plate 236 disposed below the display panel 235. According to an embodiment, the first display 230 may include a pair of reinforcement plates 237 and 238 disposed below the support plate 236. In an embodiment, the first display 230 may not include the pair of reinforcement plates 237 and 238. According to an embodiment, the display panel 235 may include a first panel area 235a corresponding to a first area (e.g., the first area 230a in FIG. 2A) of the first display 230, a second panel area 235b extending from the first panel area 235a and corresponding to a second area (e.g., the second area 230b in FIG. 2A) of the first display 230, and a third panel area 235c interconnecting the first panel area 235a and the second panel area 235b and corresponding to a folding area (e.g., the folding area 230c in FIG. 2A) of the first display 230. According to an embodiment, the support plate 236 may be disposed between the display panel 235 and a pair of support frames 261 and 262 and may be configured to have a material and a shape to provide a flat support structure for the first panel area 235a and the second panel area 235b and a bendable structure for supporting bendability of the third panel area 235c. According to an embodiment, the support plate 236 may be made of a conductive material (e.g., metal) or a non-conductive material (e.g., polymer or fiber reinforced plastics (FRP)). According to an embodiment, the pair of reinforcement plates 237 and 238 may include, between the support plate 236 and the pair of support frames 261 and 262, a first reinforcement plate 237 disposed corresponding to at least a portion of the first panel area 235a and/or the third panel area 235c, and/or a second reinforcement plate 238 disposed corresponding to at least a portion of the second panel area 235b and/or the third panel area 235c. According to an embodiment, the pair of reinforcement plates 237 and 238 may be made of a metal material (e.g., SUS) to help reinforce the ground connection structure and rigidity for the first display 230.

According to an embodiment, the second display 300 may be disposed in the space between the second housing 220 and the second rear surface cover 250. According to an embodiment, the second display 300 may be disposed in the space between the second housing 220 and the second rear surface cover 250 to be visible from the outside through substantially the entire area of the second rear surface cover 250.

According to an embodiments, at least a portion of the first support frame 261 may be coupled to the second support frame 262 to be foldable via the one or more hinge device 400 and 400-1. According to an embodiment, the electronic device 200 may include one or more wiring members 263 (e.g., a flexible printed circuit board (FPCB)) extending from at least a portion of the first support frame 261 to a portion of the second support frame 262 across the one or more hinge devices 400 and 400-1. In an embodiment, the at least one wiring member 263 may be a flexible printed circuit board (FPCB).

According to an embodiment, the first support frame 261 may extend from the first side surface frame 213 or may be disposed in a manner of being structurally coupled with the first side surface frame 213. According to an embodiment, the electronic device 200 may include a first space (e.g., the first space 2101 in FIG. 2A) provided by the first support frame 261 and the first rear surface cover 240. According to an embodiment, the first housing 210 (e.g., the first housing structure) may be configured through the coupling of the first side surface frame 213, the first support frame 261, and the first rear surface cover 240. According to an embodiment, the second support frame 262 may extend from the second side surface frame 223 or may be disposed in a manner of being structurally coupled with the second side surface frame 223. According to an embodiment, the electronic device 200 may include a second space (e.g., the second space 2201 in FIG. 2A) provided by the second support frame 262 and the second rear surface cover 250. According to an embodiment, the second housing 220 (e.g., the second housing structure) may be configured through the coupling of the second side surface frame 223, the second support frame 262, and the second rear surface cover 250. According to an embodiment, the one or more wiring members 263 and/or the one or more hinge devices 400 and 400-1 may be disposed to be at least partially supported by at least a portion of the pair of support frames 261 and 262. According to an embodiment, the at least one wiring member 263 may be arranged in a direction across the first support frame 261 and the second support frame 262 (e.g., in the x-axis direction). According to an embodiment, the at least one wiring member 263 may be disposed to have a length in a direction (e.g., the x-axis direction) substantially perpendicular to the folding axis (e.g., the y-axis or the folding axis F in FIG. 2A).

According to an embodiment, the one or more boards 270 may include a first printed circuit board 271 disposed in the first housing 210 and a second printed circuit board 272 disposed in the second housing 220. According to an embodiment, the first printed circuit board 271 and the second printed circuit board 272 may include a plurality of electronic components disposed thereon to implement various functions of the electronic device 200. According to an embodiment, the first printed circuit board 271 and the second printed circuit board 272 may be electrically connected to each other via at least one wiring member 263.

According to an embodiment, the electronic device 200 may include one or more batteries 291 and 292. According to an embodiment, the one or more batteries 291 and 292 may include a first battery 291 disposed in the first housing 210 and electrically connected to the first printed circuit board 271, and a second battery 292 disposed in the second housing 220 and electrically connected to the second printed circuit board 272. According to an embodiment, the first support frame 261 and the second support frame 262 may further include one or more swelling holes for the first battery 291 and the second battery 292.

According to an embodiment, the electronic device 200 may include one or more antennas 276 disposed in the first housing 210. According to an embodiment, the one or more antennas 276 may be disposed in the inner space of the first housing 210 (e.g., the first space 2101 in FIG. 2A), between the first battery 291 and the first rear surface cover 240. According to an embodiment, the one or more antennas 276 may include, for example, a near-field communication (NFC) antenna, a wireless charging antenna, and/or a magnetic secure transmission (MST) antenna. In an embodiment, an antenna structure may be configured by at least a portion of the first side surface frame 213 or the second side surface frame 223 and/or a portion of the first support frame 261 and the second support frame 262, or a combination thereof.

According to an embodiment, the electronic device 200 may further include at least one electronic component assembly 274 or 275 and/or additional support frames 263 disposed in the first space 2101 and/or the second space 2201. For example, the at least one electronic component assembly may include an interface connector port assembly 274 or a speaker assembly 275.

According to an embodiment, the electronic device 200 may include a first waterproof gasket WP1 disposed between the first display 230 and the first support frame 261 and a second waterproof gasket WP2 disposed between the first display 230 and the second support frame 262. According to an embodiment, the first waterproof gasket WP1 may provide at least one first waterproof space between the first display 230 and the first support frame 261. According to an embodiment, the at least one first waterproof space may accommodate an area corresponding to at least one electronic component (e.g., a camera module or a sensor module) disposed to be supported by the first support frame 261. According to an embodiment, the second waterproof gasket WP2 may provide a second waterproof space between the first display 230 and the second support frame 262. According to an embodiment, the second waterproof space may accommodate at least a portion of a bending portion folded to the rear surface of the first display 230. For example, the second waterproof space may be disposed to extend from the display panel of the first display 230 and surround at least a portion of the bending portion that is folded toward the rear surface. In an embodiment, a control circuit (e.g., a display driver IC (DDI)) and a plurality of electrical components disposed in the bending portion may be disposed in the second waterproof space, thereby being protected from external moisture and/or foreign substances.

According to an embodiment, the electronic device 200 may include a waterproof tape 241 disposed between the first rear surface cover 240 and the first housing 210. According to an embodiment, the electronic device 200 may include a bonding member 251 disposed between the second rear surface cover 250 and the second housing 220. In an embodiment, the bonding member 251 may be disposed between the second display 300 and the second housing 220. In an embodiment, the waterproof tape 241 may be replaced with the bonding member 251, and the bonding member 251 may be replaced with the waterproof tape 241.

According to an embodiment, the one or more hinge devices 400 and 400-1 may include a first hinge device 400 disposed at one end in a direction parallel to the folding axis F and a second hinge device 400-1 disposed at the other end. According to an embodiment, the first hinge device 400 and the second hinge device 400-1 may have substantially the same configuration. According to an embodiment, the electronic device 200 may include a connection module 400-2 disposed between the first hinge device 400 and the second hinge device 400-1. According to an embodiment, the connection module 400-2 may be disposed through a combination of one or more gears and/or a combination of one or more links. **In** an embodiment, the connection module 400-2 may be replaced with the first hinge device 400. **In an** embodiment, the one or more hinge devices 400 and 400-1 may be disposed at one location or three or more locations spaced apart at a predetermined interval along a direction parallel to the folding axis F. According to an embodiment, the electronic device 200 may include a first hinge plate 311 and a second hinge plate 312 connected via the one or more hinge devices 400 and 400-1. According to an embodiment, when the electronic device 200 is in the flat state, the first hinge plate 311 may form the same plane as the first housing 210, and when the electronic device 200 is in the flat state, the second hinge plate 312 may form the same plane as the second housing 220. According to an embodiment, when the electronic device 200 is in the folded state, the first display 230 may be transformed into a shape having a predetermined curved surface (e.g., a "U" shape or a water drop shape) and accommodated in the inner space of the electronic device 200 through the one or more hinge devices 400 and 400-1. According to an embodiment, when the electronic device 200 is in the folded state, the first hinge plate 311 and the second hinge plate 312 may be moved to support at least a portion of the folding area (e.g., the folding area 230c in FIG. 2A) transformed into a shape having a curved surface in the first display 230. **In an** embodiment, when the electronic device 200 is in the folded state, the first housing 210 and the second housing 220 may be moved to support substantially untransformed flat portions of the first display 230 (e.g., the first area 230a and the second area 230b in FIG. 2A). In an embodiment, the electronic device 200 is in the folded state, the first hinge plate 311 may not form the same flat surface as the first housing 210, and the second hinge plate 312 may also not form the same flat surface as the second housing 220.

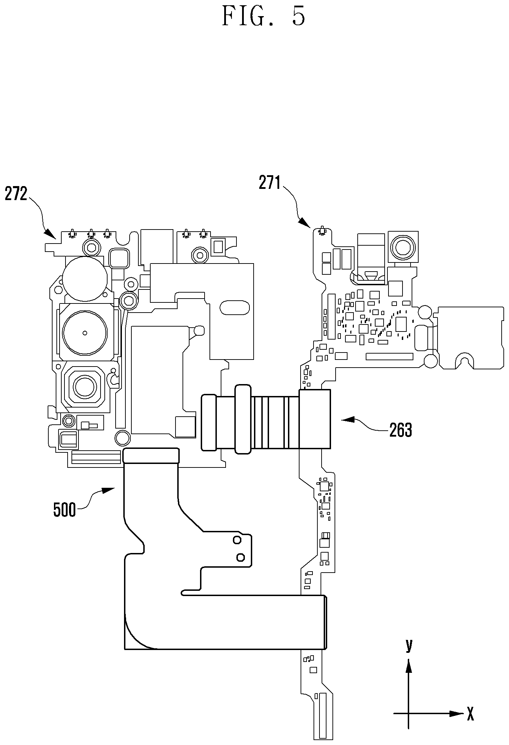

FIG. 5 is a view illustrating an example of implementing a multilayer flexible printed circuit board 500 in an electronic device 200 according to one embodiment of the disclosure.

Referring to the exploded perspective view of the electronic device 200 illustrated in FIG. 4A and FIG. 5, the electronic device 200 may include a first printed circuit board (PCB) 271, a second printed circuit board 272, a wiring member 263, and a multilayer flexible printed circuit board (multilayer FPCB) 500.

In an embodiment, the first printed circuit board 271 may be disposed in a first housing 210.

In an embodiment, the second printed circuit board 272 may be disposed in a second housing 220.

In an embodiment, the first printed circuit board 271 and the second printed circuit board 272 may include a plurality of electronic components disposed thereon to implement various functions of the electronic device 200.

In an embodiment, the first printed circuit board 271 and the second printed circuit board 272 may be electrically connected via the wiring member 263 and the multilayer flexible printed circuit board 500.

In an embodiment, the wiring member 263 may have a linear shape. The wiring member 263 may connect the first printed circuit board 271 and the second printed circuit board 272 in a first direction (e.g., the x-axis direction).

In an embodiment, the multilayer flexible printed circuit board 500 may be electrically connected to the first printed circuit board 271 in the first direction (e.g., in the x-axis direction) and electrically connected to the second printed circuit board 272 in the second direction (e.g., in the y-axis direction).

In an embodiment, the multilayer flexible printed circuit board 500 may have bending to connect the first printed circuit board 271 and the second printed circuit board 272.

In an embodiment, the multilayer flexible printed circuit board 500 may have a curve to connect the first printed circuit board 271 and the second printed circuit board 272.

In an embodiment, the multilayer flexible printed circuit board 500 may have an "L" shape.

In an embodiment, the first curved area 503a and the second curved area 503b are curved in a multilayer flexible printed circuit board 500, and the first dummy area 504a and the second dummy area 504b may be disposed within a right-angled corner where the curves of the first curved area 503a and the second curved area 503b are circumscribed.

In an embodiment, the first dummy area 504a may be included in the first curved area 503a. The second dummy area 504b may be included in the second curved area 503b.

In an embodiment, the multilayer flexible printed circuit board 500 may include areas (e.g., curved areas) that change direction to electrically connect a printed circuit board (e.g., a second printed circuit board 272) disposed in the second direction (e.g., the y-axis direction) and a printed circuit board (e.g., a first printed circuit board 271) disposed in the first direction (e.g., the x-axis direction).

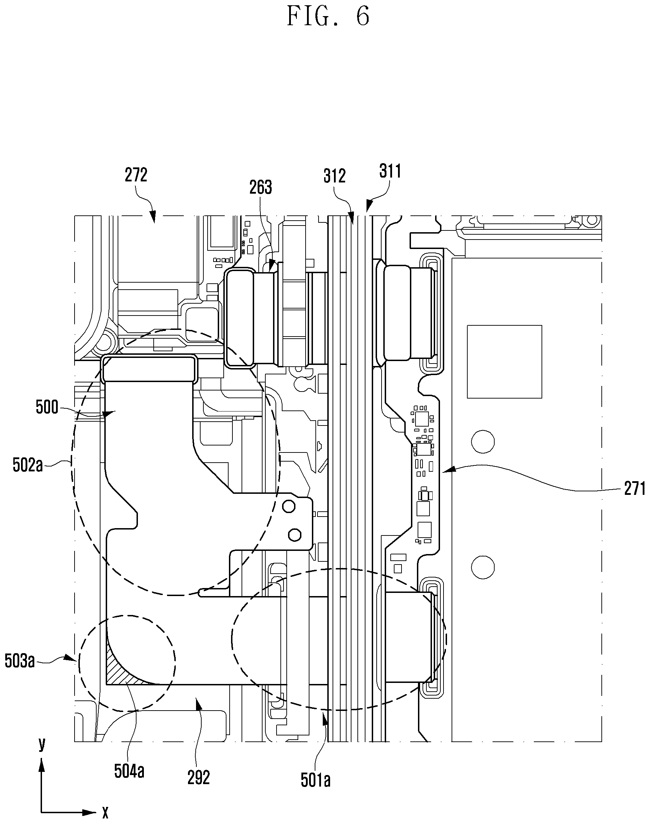

FIG. 6 is a view illustrating an example of implementing the arrangement of the multilayer flexible printed circuit board 500 and other components in the electronic device 200 according to an embodiment of the disclosure.

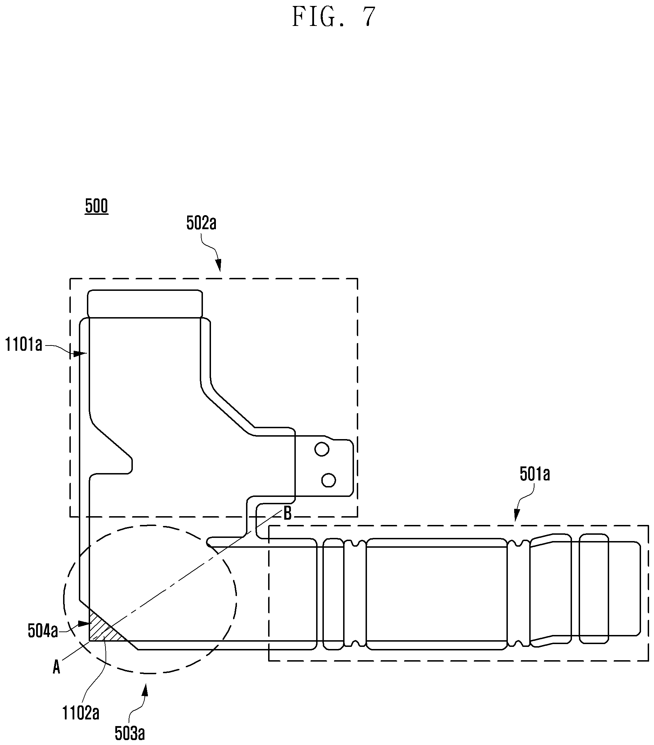

FIG. 7 is a front view of a multilayer flexible printed circuit board 500 according to an embodiment of the disclosure.

Referring to FIGS. 4A, 5, 6, and 7, the electronic device 200 may include a first printed circuit board 271, a second printed circuit board 272, a wiring member 263, a multilayer flexible printed circuit board 500, a battery (e.g., the second battery 292), and hinge plates 311 and 312.

Referring to FIGS. 6 and 7, the multilayer flexible printed circuit board 500 may include a first transmission area 501a, a second transmission area 502a, a first curved area 503a, and a first dummy area 504a.

Referring to FIGS. 6, 7, and 10, a first flexible printed circuit board 1001 may include a first transmission area 501a, a second transmission area 502a, a first curved area 503a, and a first dummy area 504a. A second flexible printed circuit board 1002 disposed below the first flexible printed circuit board 1001 may include a third transmission area (not illustrated), a fourth transmission area (not illustrated), a second curved area 503b, and a second dummy area 504b.

In an embodiment, the first transmission area 501a may meet the second transmission area 502b at a specified angle (e.g., 90 degrees). Alternatively, the first transmission area 501a may intersect the second transmission area 502b at a specified angle (e.g., 90 degrees).

In an embodiment, the first curved area 503a and the first dummy area 504a may be disposed in an area where the first transmission area 501a meets the second transmission area 502b.

In an embodiment, in the multilayer flexible printed circuit board 500, the second flexible printed circuit board 1002 may be disposed on a lower layer of the first flexible printed circuit board 1001. The first flexible printed circuit board 1001 and the second flexible printed circuit board 1002 may be spaced apart from each other.

In an embodiment, the multilayer flexible printed circuit board 500 may include, on a lower layer of the first transmission area 501a, a third transmission area (not illustrated) that has the same shape as the first transmission area 501a and is spaced apart from the first transmission area 501a.

In an embodiment, the multilayer flexible printed circuit board 500 may include, on a lower layer of the second transmission area 502a, a fourth transmission area (not illustrated) that has the same shape as the second transmission area 502a and is spaced apart from the second transmission area 502a.

In an embodiment, the multilayer flexible printed circuit board 500 may include, on a lower layer of the first curved area 503a, a second curved area 503b that has the same shape as the first curved area 503a and is spaced apart from the first curved area 503a.

In an embodiment, the multilayer flexible printed circuit board 500 may include, on a lower layer of the first dummy area 504a, a second dummy area 504b that has the same shape as the first dummy area 504a and is spaced apart from the first dummy area 504a.

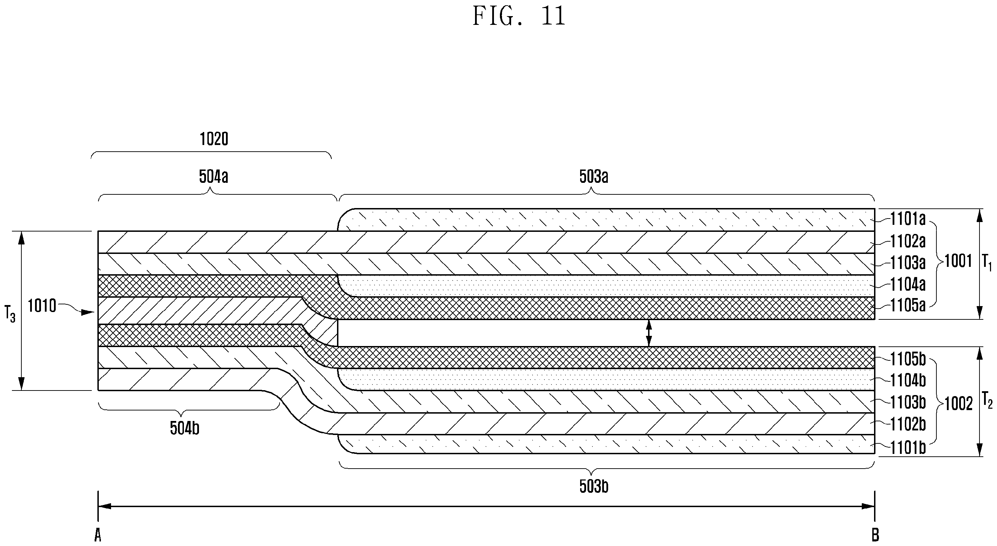

In an embodiment, the first dummy area 504a and the second dummy area 504b may not include an electromagnetic interference shielding film (e.g., the first electromagnetic interference shielding film 1101a in FIG. 11 or the second electromagnetic interference shielding film 1101b in FIG. 11), and a conductive layer (e.g., the first conductive layer 1104a in FIG. 11 or the second conductive layer 1104b in FIG. 11).

In an embodiment, the first dummy area 504a and the second dummy area 504b may not include a conductive layer for signal transmission (e.g., the first conductive layer 1104a in FIG. 11 or the second conductive layer 1104b in FIG. 11).

In an embodiment, the first dummy area 504a may be thinner than the first curved area 503a because it does not include an electromagnetic interference shielding film (e.g., the first electromagnetic interference shielding film 1101a in FIG. 11) and a conductive layer (e.g., the first conductive layer 1104a in FIG. 11) unlike the first curved area 503a.

In an embodiment, the second dummy area 504b may be thinner than the second curved area 503b because it does not include an electromagnetic interference shielding film (e.g., the second electromagnetic interference shielding film 1101b in FIG. 11) and a conductive layer (e.g., the second conductive layer 1104b in FIG. 11) unlike the second curved area 503b.

In an embodiment, the first dummy area 504a may include a cover layer (e.g., the first cover film 1102a in FIG. 11), a film bonding layer (e.g., the first film bonding layer 1103a in FIG. 11), and an insulating layer (e.g., the first insulating layer 1105a in FIG. 11).

In an embodiment, the second dummy area 504b may include a cover layer (e.g., the second cover film 1102b in FIG. 11), a film bonding layer (e.g., the second film bonding layer 1103b in FIG. 11), and an insulating layer (e.g., the second insulating layer 1105b in FIG. 11).

In an embodiment, the first curved area 503a and the second curved area 503b are curved in a multilayer flexible printed circuit board 500, and the first dummy area 504a and the second dummy area 504b may be disposed within a right-angled corner where the curves of the first curved area 503a and the second curved area 503b are circumscribed.

In an embodiment, the first dummy area 504a and the second dummy area 504b are bonded with a bonding layer (e.g., the bonding layer 1010 in FIG. 11) to form a bonding area (e.g., the bonding area 1020 in FIG. 11), and the first curved area 503a and the second curved area 503b may be combined or formed with a small thickness.

Referring to FIG. 6, the bonding area where the first dummy area 504a and the second dummy area 504b are bonded is placed on a battery (e.g., the second battery 292). Since the bonding thickness of the first dummy area 504a and the second dummy area 504b is smaller than that of the first curved area 503a and the second curved area 503b, a sufficient mounting space for a battery (e.g., the second battery 292) can be ensured.

In an embodiment, the third transmission area (not illustrated) may meet the fourth transmission area (not illustrated) at a specified angle (e.g., 90 degrees). Alternatively, the third transmission area (not illustrated) may intersect the fourth transmission area (not illustrated) at a specified angle (e.g., 90 degrees).

In an embodiment, the second curved area 503b and the second dummy area 504b may be disposed in an area where the third transmission area (not illustrated) meets the fourth transmission area (not illustrated).

In an embodiment, the multilayer flexible printed circuit board 500 may be at least partially disposed above a battery (e.g., the second battery 292).

In an embodiment, the multilayer flexible printed circuit board 500 may be disposed such that the curved areas 503a and 503b or the dummy areas 504a and 504b may be disposed above a battery (e.g., the second battery 292).

In an embodiment, the second printed circuit board 272 may be disposed parallel to a battery (e.g., the second battery 292) in the first direction (e.g., the y-axis direction) or a vertical direction (e.g., the y-axis direction) in the second housing 220. The second printed circuit board 272 may be arranged on top of a battery (e.g., the second battery 292), and the battery (e.g., the second battery 292) may be disposed on the bottom of the second printed circuit board 272.

In an embodiment, the multilayer flexible printed circuit board 500 may have at least a portion passing below the hinge plates 311 and 312 to be connected to the first printed circuit board 271.

In an embodiment, the multilayer flexible printed circuit board 500 may have at least a portion of the transmission area (e.g., the first transmission area 501a or the third transmission area (not illustrated)) pass under the hinge plates 311 and 312 to be connected to the first printed circuit board 271.

In an embodiment, the multilayer flexible printed circuit board 500 may be at least partially fixed by the hinge plates 311 and 312.

In an embodiment, at least a portion of the transmission area (e.g., the first transmission area 501a or the third transmission area (not illustrated)) of the multilayer flexible printed circuit board 500 may be fixed by the hinge plates 311 and 312.

In an embodiment, the multilayer flexible printed circuit board 500 may be electrically connected to the first printed circuit board 271 in the first direction (e.g., in the x-axis direction) and electrically connected to the second printed circuit board 272 in the second direction (e.g., in the y-axis direction).

In an embodiment, the multilayer flexible printed circuit board 500 may have bending to connect the first printed circuit board 271 and the second printed circuit board 272.

In an embodiment, the multilayer flexible printed circuit board 500 may have a curve to connect the first printed circuit board 271 and the second printed circuit board 272.

In an embodiment, the multilayer flexible printed circuit board 500 may have an "L" shape.

In an embodiment, the first curved area 503a and the second curved area 503b are curved in a multilayer flexible printed circuit board 500, and the first dummy area 504a and the second dummy area 504b may be disposed within a right-angled corner where the curves of the first curved area 503a and the second curved area 503b are circumscribed.

In an embodiment, the multilayer flexible printed circuit board 500 may include areas (e.g., curved areas) that change direction to electrically connect a printed circuit board (e.g., a second printed circuit board 272) disposed in the second direction (e.g., the y-axis direction) and a printed circuit board (e.g., a first printed circuit board 271) disposed in the first direction (e.g., the x-axis direction).

Referring to FIGS. 7 and 11, the first transmission area 501a, the second transmission area 502a, the third transmission area (not illustrated), the fourth transmission area (not illustrated), the first curved area 503a, and the second curved area 503b of the multilayer flexible printed circuit board 500 may be at least partially covered with an electromagnetic interference shielding film (or electromagnetic interference shielding layer) 1101a or 1101b.

The first dummy area 504a and the second dummy area 504b may not include an electromagnetic interference shielding film (or electromagnetic interference shielding layer) 1101a or 1101b, and may expose the cover layer 1102a or 1102b to the outside.

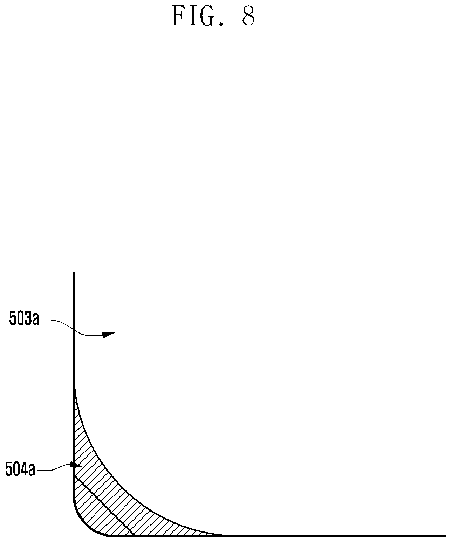

FIG. 8 is a view schematically illustrating curved areas (e.g., a first curved area 503a and a second curved area 503b) and dummy areas (e.g., a first dummy area 504a and a second dummy area 504b) according to an embodiment of the disclosure.

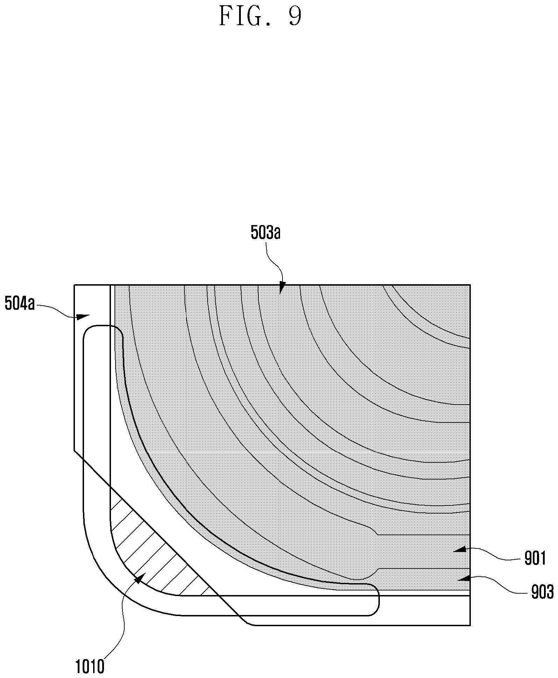

FIG. 9 is a view specifically illustrating curved areas (e.g., a first curved area 503a and a second curved area 503b) and dummy areas (e.g., a first dummy area 504a and a second dummy area 504b) according to an embodiment of the disclosure.

Referring to FIGS. 8 and 9 , the first curved area 503a and the second curved area 503b of the multilayer flexible printed circuit board 500 may be covered with an electromagnetic interference shielding film (or electromagnetic interference shielding layer) 1101a or 1101b.

In an embodiment, the first dummy area 504a and the second dummy area 504b may not include an electromagnetic interference shielding film (or electromagnetic interference shielding layer) 1101a or 1101b, and may expose the cover layer 1102a or 1102b to the outside.

In an embodiment, the first curved area 503a and the second curved area 503b may include a signal line 901 and/or a ground line 903 that electrically interconnects the first printed circuit board 271 and the second printed circuit board 272 by including a conductive layer.

In an embodiment, the first dummy area 504a and the second dummy area 504b may not have a conductive layer. No conductive layer may be present in the first dummy area 504a and the second dummy area 504b.

In an embodiment, the first dummy area 504a and the second dummy area 504b may include a bonding layer 1010 therebetween, and the first dummy area 504a and the second dummy area 504b may be bonded to each other due to the bonding layer 1010.

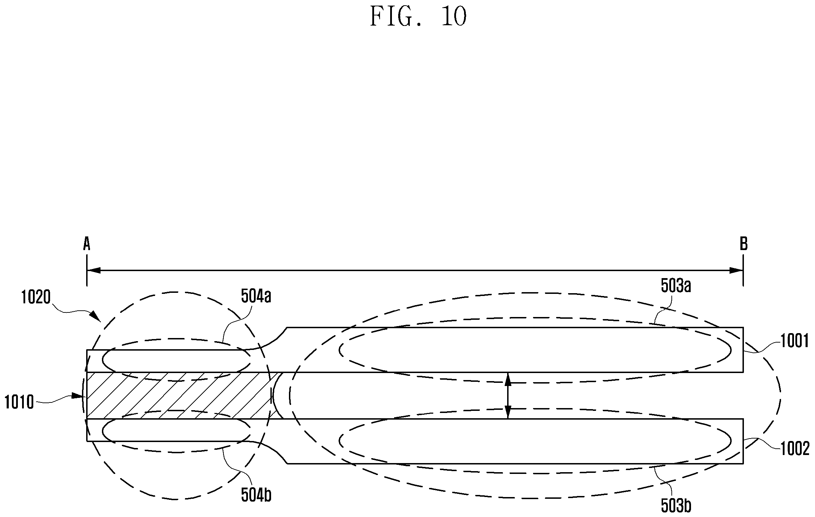

FIG. 10 is a view schematically illustrating a cross-section of the multilayer flexible printed circuit board 500 of FIG. 7 according to an embodiment of the disclosure cut along line A-B.

FIG. 11 is a view specifically illustrating a cross-section of the multilayer flexible printed circuit board 500 of FIG. 7 according to an embodiment of the disclosure cut along line A-B.

Referring to FIGS. 10 and 11, the multilayer flexible printed circuit board 500 may include a first flexible printed circuit board 1001 and a second flexible printed circuit board 1002.

In an embodiment, the multilayer flexible printed circuit board 500 may include a bonding area 1020 where the first flexible printed circuit board 1001 and the second flexible printed circuit board 1002 are coupled. The bonding area 1020 may be an area where the first dummy area 504a and the second dummy area 504b are bonded by the bonding layer 1010.

In an embodiment, in the multilayer flexible printed circuit board 500, the second flexible printed circuit board 1002 may be disposed on a lower layer of the first flexible printed circuit board 1001. The first flexible printed circuit board 1001 and the second flexible printed circuit board 1002 may be spaced apart from each other.

In an embodiment, the first flexible printed circuit board 1001 may include a first transmission area 501a, a second transmission area 502a, a first curved area 503a, and a first dummy area 504a. The second flexible printed circuit board 1002 disposed below the first flexible printed circuit board 1001 may include a third transmission area (not illustrated), a fourth transmission area (not illustrated), a second curved area 503b, and a second dummy area 504b.

In an embodiment, the first flexible printed circuit board 1001 may include a first curved area 503a and a first dummy area 504a. The second flexible printed circuit board 1002 may include a second curved area 503b and a second dummy area 504b.

In an embodiment, the first flexible printed circuit board 1001 may include a first electromagnetic interference (EMI) shielding film (or electromagnetic interference shielding layer) 1101a, a first cover film (or cover layer) 1102a, a first film bonding layer 1103a, a first conductive layer 1104a, and a first insulating layer 1105a.

In an embodiment, in the first flexible printed circuit board 1001, the first electromagnetic interference shielding film 1101a, the first cover film 1102a, the first film bonding layer 1103a, the first conductive layer 1104a, and the first insulating layer 1105a may be coupled to each other.

In an embodiment, the first film bonding layer 1103a may allow the first cover film 1102a and the first conductive layer 1104a to be attached thereto.

In an embodiment, the first conductive layer 1104a may be a thin copper layer.

In an embodiment, the first insulating layer 1105a may be made of polyimide.

In an embodiment, the first dummy area 504a of the first flexible printed circuit board 1001 may include a first cover film (or cover layer) 1102a extending from the first curved area 503a, a first film bonding layer 1103a, and a first insulating layer 1105a.

In an embodiment, the second flexible printed circuit board 1002 may include a second electromagnetic interference shielding film (or electromagnetic interference shielding layer) 1101a, a second cover film (or cover layer) 1102b, a second film bonding layer 1103b, a second conductive layer 1104b, and a second insulating layer 1105b.

In an embodiment, in the second flexible printed circuit board 1002, the second electromagnetic interference shielding film 1101b, the second cover film 1102b, the second film bonding layer 1103b, the second conductive layer 1104b, and the second insulating layer 1105b may be coupled to each other.

In an embodiment, the second film bonding layer 1103b may allow the second cover film 1102b and the second conductive layer 1103b to be attached thereto.

In an embodiment, the second conductive layer 1104b may be a thin copper layer.

In an embodiment, the second insulating layer 1105a may be made of polyimide.

In an embodiment, the second dummy area 504b of the second flexible printed circuit board 1002 may include a second cover film (or cover layer) 1102b extending from the second curved area 503b, a second film bonding layer 1103b, and a second insulating layer 1105b.

In an embodiment, the first insulating layer 1105a and the second insulating layer 1105b may be bonded with the bonding layer 1010.

The thickness of the first flexible printed circuit board 1001 may be a first length T1, and the thickness of the second flexible printed circuit board 1002 may be a second length T2.

The thickness of the bonding area 1020 where the first dummy area 504a and the second dummy area 504b are coupled may be a third length T3.

The first dummy area 504a and the second dummy area 504b are coupled with the bonding layer 1010, but do not include the first electromagnetic interference shielding film (or electromagnetic interference shielding layer) 1101a, the second electromagnetic interference shielding film (or electromagnetic interference shielding layer) 1101b, the first conductive layer 1104a, and the second conductive layer 1104b. Therefore, the thickness T3 of the first dummy area 504a and the second dummy area 504b may be smaller than the sum of the thickness T1 of the first flexible printed circuit board 1001 and the thickness T2 of the second flexible printed circuit board 1002.

The electronic device 200 may include a hinge (e.g., the hinge devices 400 and 400-1 in FIG. 4A), a first housing (e.g., the first housing 210) connected to the hinge (e.g., the hinge devices 400 and 400-1 in FIG. 4A), and a second housing (e.g., the second housing 220) connected to the hinge (e.g., the hinge devices 400 and 400-1 in FIG. 4A) and configured to be folded with the first housing (e.g., the first housing 210) about the hinge (e.g., the hinge devices 400 and 400-1 in FIG. 4A).

The electronic device 200 may include a first printed circuit board 271 included in the first housing (e.g., the first housing 210), a second printed circuit board 272 included in the second housing (e.g., the second housing 220), a battery (e.g., the second battery 292) included in the second housing (e.g., the second housing 220) and disposed in a direction perpendicular to the second printed circuit board 272; and a multilayer flexible printed circuit board 500 placed on the battery (e.g., the second battery 292) to connect the first printed circuit board 271 and the second printed circuit board 272.

The multilayer flexible printed circuit board 500 may include a first flexible printed circuit board (FPCB) (e.g., the first flexible printed circuit board 1001) including a first curved area 503a in which a conductive layer for signal transmission is disposed, and a second FPCB (e.g., the second flexible printed circuit board 1002) including a second curved area 503b in which a conductive layer for signal transmission is disposed. The first FPCB (e.g., the first flexible printed circuit board 1001) may include a first dummy area 504a extending from the first curved area 503a, the second FPCB (e.g., the second flexible printed circuit board 1002) may include a second dummy area 504b extending from the second curved area 503b, and may include a bonding layer that bonds the first dummy area 504a and the second dummy area 504b.

The first FPCB (e.g., the first flexible printed circuit board 1001) may include a first transmission area 501a extending in a first direction, and a second transmission area 502a extending in a second direction perpendicular to the first direction, and the first curved area 503a may be included in an area where the first transmission area 501a and the second transmission area 502a meet.

The first curved area 503a may include a first electromagnetic interference shielding layer 1101a, a first cover layer 1102a, a first conductive layer 1104a, and a first insulating layer 1105a.

The first dummy area 504a may include the first cover layer 1102a extending from the first curved area 503a, and the first insulating layer 1105a extending from the first curved area 503a.

The second FPCB (e.g., the second flexible printed circuit board 1002) may include a third transmission area (not illustrated) extending in a first direction, and a fourth transmission area (not illustrated) extending in a second direction perpendicular to the first direction.

The second curved area 503b may be included in an area where the third transmission area (not illustrated) and the fourth transmission area (not illustrated) meet.

In the electronic device 200, the first transmission area 501a and the third transmission area (not illustrated) may be connected to the first printed circuit board 271, and the second transmission area 502a and the fourth transmission area (not illustrated) may be connected to the second printed circuit board 272.

The second curved area 503b may include a second electromagnetic interference shielding layer 1101b, a second cover layer 1102b, a second conductive layer, and a second insulating layer.

The second dummy area 504b may include the second cover layer 1102b extending from the second curved area 503b, and the second insulating layer extending from the second curved area 503b.

The first curved area 503a and the second curved area 503b may be placed on the battery (e.g., the second battery 292).

The first dummy area 504a and the second dummy area 504b may be placed on the battery (e.g., the second battery 292).

The multilayer flexible printed circuit board 500 may include a first flexible printed circuit board (FPCB) (e.g., the first flexible printed circuit board 1001) including a first curved area 503a in which a conductive layer for signal transmission is disposed, and a second FPCB (e.g., the second flexible printed circuit board 1002) including a second curved area 503b in which a conductive layer for signal transmission is disposed. The first FPCB (e.g., the first flexible printed circuit board 1001) may include a first dummy area 504a extending from the first curved area 503a, the second FPCB (e.g., the second flexible printed circuit board 1002) may include a second dummy area 504b extending from the second curved area 503b, and may include a bonding layer that bonds the first dummy area 504a and the second dummy area 504b.

The first FPCB (e.g., the first flexible printed circuit board 1001) may include a first transmission area 501a extending in a first direction, and a second transmission area 502a extending in a second direction perpendicular to the first direction.

The first curved area 503a may be included in an area where the first transmission area 501a and the second transmission area 502a meet.

The first curved area 503a may include a first electromagnetic interference (EMI) shielding layer, a first cover layer 1102a, a first conductive layer 1104a, and a first insulating layer 1105a.

The first dummy area 504a may include the first cover layer 1102a extending from the first curved area 503a, and the first insulating layer 1105a extending from the first curved area 503a.

The second FPCB (e.g., the second flexible printed circuit board 1002) may include a third transmission area (not illustrated) extending in a first direction, and a fourth transmission area (not illustrated) extending in a second direction perpendicular to the first direction, and the second curved area 503a may be included in an area where the third transmission area (not illustrated) and the fourth transmission area (not illustrated) meet.

In the multilayer printed circuit board 500, the first transmission area 501a and the third transmission area (not illustrated) may form an interlayer structure in the first direction, and the second transmission area 502a and the fourth transmission area (not illustrated) may form an interlayer structure in the second direction.

The second curved area 503b may include a second electromagnetic interference shielding layer 1101b, a second cover layer 1102b, a second conductive layer, and a second insulating layer.

The first transmission area 501a and the second transmission area 502a may include the first electromagnetic interference shielding layer 1101a extending from the first curved area 503a, the first cover layer 1102a extending from the first curved area 503a, the first conductive layer 1104a extending from the first curved area 503a, and the first insulating layer 1105a extending from the first curved area 503a.

The third transmission area (not illustrated) and the fourth transmission area (not illustrated) may include the second electromagnetic interference shielding layer 1101b extending from the second curved area 503b, the second cover layer 1102b extending from the second curved area 503b, the second conductive layer extending from the second curved area 503b, and the second insulating layer extending from the second curved area 503b.

The second dummy area 504b may include the second cover layer 1102b extending from the second curved area 503b, and the second insulating layer extending from the second curved area 503b.

The electronic device according to various embodiments set forth herein may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that the embodiments and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C" may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". The "module" may be a single integrated component, or a minimum unit or part thereof, adapted to perform one or more functions. For example, according to an embodiment, the "module" may be implemented in the form of an application-specific integrated circuit (ASIC).

Various embodiments of the disclosure may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions each may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in any other element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device comprising:
a hinge;
a first housing connected to the hinge;
a second housing connected to the hinge and configured to be folded relative to the first housing about the hinge;
a first printed circuit board (PCB) included in the first housing;
a second printed circuit board (PCB) included in the second housing;
a battery included in the second housing and disposed in a direction perpendicular to the second PCB;
a multilayer flexible printed circuit board (FPCB) placed on the battery to connect the first PCB and the second PCB,
wherein the multilayer FPCB comprises:
a first FPCB comprising a first curved area in which a conductive layer for signal transmission is disposed, the first FPCB comprising a first dummy area extending from the first curved area;
a second FPCB comprising a second curved area in which a conductive layer for signal transmission is disposed, the second FPCB comprising a second dummy area extending from the second curved area; and
a bonding layer to which first dummy area and the second dummy area are bonded.

2. The electronic device of claim 1, wherein the first FPCB comprises:
a first transmission area extending in a first direction; and
a second transmission area extending in a second direction perpendicular to the first direction, and
wherein the first curved area is included in an area where the first transmission area and the second transmission area meet.

3. The electronic device of claim 2, wherein the first curved area comprises:
a first electromagnetic interference (EMI) shielding layer;
a first cover layer,
a first conductive layer; and
a first insulating layer.

4. The electronic device of claim 3, wherein the first dummy area comprises:
the first cover layer extending from the first curved area; and
the first insulating layer extending from the first curved area.

5. The electronic device of claim 2, wherein the second FPCB comprises:
a third transmission area extending in the first direction; and
a fourth transmission area extending in the second direction perpendicular to the first direction, and
wherein the second curved area is included in an area where the third transmission area and the fourth transmission area meet.

6. The electronic device of claim 5, wherein the first transmission area and the third transmission area are connected to the first PCB, and
wherein the second transmission area and the fourth transmission area are connected to the second PCB.

7. The electronic device of claim 5, wherein the second curved area comprises:
a second electromagnetic interference shielding layer;
a second cover layer;
a second conductive layer; and
a second insulating layer.

8. The electronic device of claim 7, wherein the second dummy area comprises:
the second cover layer extending from the second curved area; and
the second insulating layer extending from the second curved area.

9. The electronic device of claim 1, wherein the first curved area and the second curved area are placed on the battery.

10. The electronic device of claim 1, wherein the first dummy area and the second dummy area are placed on the battery.

11. A multilayer flexible printed circuit board comprising:
a first FPCB comprising a first curved area in which a conductive layer for signal transmission is disposed, the first FPCB comprising a first dummy area extending from the first curved area;
a second FPCB comprising a second curved area in which a conductive layer for signal transmission is disposed, the second FPCB comprises a second dummy area extending from the second curved area; and
a bonding layer to which the first dummy area and the second dummy area are bonded.

12. The multilayer flexible printed circuit board of claim 11, wherein the first FPCB comprises:
a first transmission area extending in a first direction; and
a second transmission area extending in a second direction perpendicular to the first direction, and
wherein the first curved area is included an area where the first transmission area and the second transmission area meet.

13. The multilayer flexible printed circuit board of claim 12, wherein the first curved area comprises:
a first electromagnetic interference (EMI) shielding layer;
a first cover layer;
a first conductive layer; and
a first insulating layer.

14. The multilayer flexible printed circuit board of claim 13, wherein the first dummy area comprises the first cover layer extending from the first curved area and the first insulating layer extending from the first curved area.

15. The multilayer flexible printed circuit board of claim 12, wherein the second FPCB comprises:
a third transmission area extending in the first direction; and
a fourth transmission area extending in the second direction perpendicular to the first direction, and
wherein the second curved area is included in an area where the third transmission area and the fourth transmission area meet.
